# EUROPEAN PATENT APPLICATION

(11) **EP 2 934 073 A1**
(43) Date of publication of application: **21.10.2015**
(21) Application number: 13862689.0
(22) Date of filing: 06.12.2013
(51) Int. Cl.: H05K 1/09, H05K 3/46, H05K 7/20

(54) **PRINTED CIRCUIT BOARD AND METHOD OF MANUFACTURING SAME**

(30) Priority: 14.12.2012 KR 20120146263
(71) Applicant: Tyco Electronics AMP Korea Ltd., Gyeongsangbuk-do 712-837 (KR)
(72) Inventor: CHOI, Yang Yoon, Gyeongsangbuk-do 712-837 (KR); BEAK, Ok Ky, Siheung-si Gyeonggi-do 429-854 (KR)
(74) Representative: Johnstone, Douglas Ian
(86) International application number: PCT/KR2013/011248
(87) International publication number: WO 2014/092386

(57) **Abstract**

Disclosed are a printed circuit board capable of improving heat dissipation and strength against warping through the use of aluminum, and a method of manufacturing same. The printed circuit board may be configured to include: a core portion formed of an aluminum material; a base layer formed of an aluminum material and bonded on both side surfaces of the core portion; a bonding member interposed between the core portion and the base layer in order to bond the base layer to the core portion; a via hole formed through the core portion, the bonding member, and the base layer; a substitution layer formed to ionize a portion exposed to the surface of the base layer and the inside of the via hole; and a plate layer formed on the substitution layer and having a circuit pattern formed thereon.

## Description

### Technical Field

The present invention relates to a printed circuit board (PCB) using aluminum and a method of manufacturing the PCB that may increase heat dissipation and bending strength using aluminum.

### Background Art

In general, a printed circuit board (PCB) is a component in which electric wirings are integrated to allow various devices to be populated therein or to be electrically connected to one another. A technological development has been promoting production of PCBs having various forms and functions. A demand for such PCBs has been increasing with a growth of industries using the PCBs and relating to, for example, home appliances, communication devices, semiconductor equipment, industrial machinery, and electrical control of a vehicle. In addition, PCB products are being transformed into a miniaturized, light-weight, and high value-added products as electronic components become smaller and more sophisticated.

A predominant feature of such electronic components may be discovered in that various added complex functions consume a considerable amount of power and generate a greater amount of heat. Thus, a degree of heat generated from an electronic product may be a factor used to evaluate a degree of satisfaction with the electronic product and a standard of purchasing.

Conventionally, a multilayer PCB is manufactured by using a copper-clad laminate (CCL) as a base substrate, forming a circuit pattern on the CCL, and additionally laminating a layer. However, such a conventional method of manufacturing the multilayer PCB may have a limitation to improve a heat dissipation characteristic of the PCB due to a limited material, for example, copper (Cu).

### Disclosure of Invention

### Technical Goals

To handle such issues described in the foregoing, an aspect of the present invention provides a printed circuit board (PCB) and a method of manufacturing the PCB to increase a heat dissipation function and bending strength.

Another aspect of the present invention provides a PCB and a method of manufacturing the PCB to prevent damage or cracking in the PCB despite harsh environmental conditions applied to a vehicle and improve reliability of a product.

Still another aspect of the present invention provides a PCB and a method of manufacturing the PCB to reduce a weight of electronic components for a vehicle by using aluminum which is relatively lighter than copper.

Yet another aspect of the present invention provides a PCB and a method of manufacturing the PCB to reduce an amount of time and cost for manufacturing the PCB.

Further another aspect of the present invention provides a PCB and a method of manufacturing the PCB to manufacture various forms of circuits as necessary based on aluminum bonded onto an insulation layer by a method of layering the aluminum on the insulation layer, and to simplify a product through circuit integration in accordance with the method.

### Technical Solutions

According to an aspect of the present invention, there is provided a printed circuit board (PCB) including a core portion formed of an aluminum material, a base layer formed of an aluminum material and bonded on both sides of the core portion, a bonding member interposed between the core portion and the base layer to bond the base layer to the core portion, a via hole formed to penetrate the core portion, the bonding member, and the base layer, and a substitution layer formed to zincify a surface of the base layer and a portion exposed to an inner side of the via hole, and a plating layer formed on the substitution layer and including a circuit pattern formed thereon.

The PCB may further include a metal layer formed to metalize a portion of the bonding member exposed to the inner side of the via hole. The substitution layer may be formed on a portion from which the metal layer is excluded, and the plating layer may be formed to cover the metal layer. The plating layer may include a substitution plating layer formed on a surface of the substitution layer through electrolytic or electroless plating, and an electrolytic plating layer formed on the substitution plating layer through the electrolytic plating. The substitution plating layer may be formed on the surface of the substitution layer from which the metal layer is excluded or formed to cover a portion of the metal layer, and the electrolytic plating layer may be formed to cover a portion of the metal layer on which the substitution plating layer is not formed.

The core portion may be formed of the aluminum material having a predetermined thickness, and may be a metal core layer including a core pattern formed thereon. The core portion may include a metal core layer formed of an aluminum material having a predetermined thickness and including a core pattern formed thereon, a core base layer formed of an aluminum material and bonded on both sides of the metal core layer, and a core bonding member interposed between the metal core layer and the core base layer to bond the core base layer to the metal core layer. The PCB may further include a circuit pattern formed on the core base layer, and an insulation layer may be formed on the core base layer. The metal layer may be formed to metalize a portion of the bonding member, the core bonding member, and the insulation layer, which is exposed to the inner side of the via hole, and the plating layer may be formed to cover the metal layer. The PCB may further include an insulation layer formed between the core portion and the bonding member, and a metal layer formed to metalize a portion of the core bonding member, the bonding member, and the insulation layer, which is exposed to the inner side of the via hole. The substitution layer may be formed on a portion from which the metal layer is excluded, and the plating layer may be formed to cover the metal layer.

The core pattern may be formed as at least one hole penetrating the metal core layer, and the hole may be formed as a pattern or arranged regularly or irregularly. The metal core layer may be formed by performing surface treatment to form surface roughness.

The PCB may include an insulation layer formed on the circuit pattern, a second base layer formed of an aluminum material and bonded to the insulation layer using a second bonding member, a second substitution layer formed to zincify a surface of the second base layer, and a second plating layer formed on the second substitution layer. The insulation layer, the second base layer, the second substitution layer, and the second plating layer may be repetitively layered at least once, and the PCB may include a second via hole formed to fully penetrate the insulation layer, the second base layer, the second substitution layer, and the second plating layer. The PCB may further include a second metal layer formed to metalize a portion of the bonding member, the insulation layer, and the second bonding member, which is exposed to an inner side of the second via hole. The second substitution layer may be formed on a portion from which the second metal layer is excluded, and the second plating layer may be formed to cover the second metal layer.

The core portion may include a metal core layer formed of an aluminum material having a predetermined thickness and including a core pattern formed thereon, a core bonding member formed on both sides of the metal core layer, a core base layer formed of an aluminum material and bonded to the metal core layer using the core bonding member, a second core bonding member formed on each of the core base layer, and a second core base layer formed of an aluminum material and bonded to each of the core base layer using the second core bonding member.

According to another aspect of the present invention, there is provided a method of manufacturing a PCB, the method including providing a core portion of an aluminum material, bonding a base layer having a predetermined thickness onto the core portion using a bonding member, forming a via hole penetrating the core portion, the bonding member, and the base layer, and forming a substitution layer by zincifying a surface of the base layer and a portion exposed to an inner side of the via hole, forming a plating layer on the substitution layer, and forming a predetermined circuit pattern on the plating layer.

The method may further include forming a metal layer to metalize a portion of the bonding member exposed to the inner side of the via hole. The forming of the substitution layer may include forming the substitution layer on a portion from which the metal layer is excluded, and the forming of the plating layer may include forming the plating layer to cover the metal layer. The forming of the plating layer may include forming a substitution plating layer on a surface of the substitution layer using electrolytic or electroless plating, and forming an electrolytic plating layer formed of a cupric material and formed on the substitution plating layer through the electrolytic plating. The substitution plating layer may be formed on the surface of the substitution layer from which the metal layer is excluded or formed to cover a portion of the metal layer, and the electrolytic plating layer may be formed to cover a portion of the metal layer on which the substitution plating layer is not formed.

The core portion may be formed of the aluminum material having a predetermined thickness and formed as a metal core layer on which a core pattern is formed. The method may further include performing surface treatment to form surface roughness of the metal core layer. The providing of the core portion may include providing the metal core layer formed of the aluminum material having the predetermined thickness, forming a core pattern on the metal core layer, and bonding a core base layer of an aluminum material on both sides of the metal core layer on which the core pattern is formed using a core bonding member. The method may further include forming a second circuit pattern on the core base layer, and providing an insulation layer on the core base layer. The method may further include bonding a second core base layer of an aluminum material to each of the core base layer using a second core bonding member. The method may further include forming an insulation layer to fill the circuit pattern, bonding a second base layer of an aluminum material to the insulation layer using a second bonding member, forming a second via hole penetrating the metal core layer, the bonding member, the base layer, the insulation layer, the second bonding member, and the second base layer, and forming a metal layer to metalize a surface of the bonding member and the second bonding member, which is exposed to an inner side of the second via hole, forming a substitution layer by performing surface treatment to zincify a surface of the second base layer, and a portion of the second base layer, the base layer, and the insulation layer, which is exposed to the inner side of the second via hole, apart from the metal layer, and forming a plating layer on the substitution layer using electrolytic or electroless plating, and forming a circuit pattern on the plating layer.

The core pattern may be formed as at least one hole penetrating the metal core layer, and the hole may be formed as a pattern or arranged regularly or irregularly. The method may further include performing surface treatment to form surface roughness of the metal core layer.

The method may further include forming a secondary substrate by forming the circuit pattern, layering two secondary substrates on which the circuit pattern is formed, forming an insulation layer between the layered secondary substrates and on an uppermost face and a lowermost face of the secondary substrate, bonding a second base layer of an aluminum material onto the insulation layer using a second bonding member, forming a via hole penetrating the layered secondary substrates, the insulation layer, the second bonding member, and the second base layer, and forming a metal layer to metalize a portion of the bonding member and the second bonding member of the secondary substrate, which is exposed to an inner side of the via hole, forming a substation layer by performing a surface treatment to zincify a surface of the second base layer, and a portion of the second base layer, the base layer, and the insulation layer, which is exposed to the inner side of the via hole, apart from the metal layer, and forming a plating layer on the substitution layer using electrolytic or electroless plating, and forming a circuit pattern on the plating layer.

### Effects of Invention

According to embodiments of the present invention, using a polyimide bonding sheet that may absorb a change rate based on a thermal expansion coefficient of aluminum may prevent damage to a substrate despite harsh conditions of a drastic change in vibration and temperature and thus, may improve reliability of a product.

According to embodiments of the present invention, a printed circuit board (PCB) and a method of manufacturing the PCB may enable formation of surface roughness of a base layer, reduction in an amount of time for manufacturing the PCB, and reduction in a cost for manufacturing the PCB using a relatively inexpensive aluminum.

According to embodiments of the present invention, a PCB and a method of manufacturing the PCB may enable reduction in a cost for manufacturing the PCB by applying an existing layering, plating, and circuit forming method, and enable improvement in current carrying, heat dissipation, and bending strength.

According to embodiments of the present invention, a PCB and a method of manufacturing the PCB may enable implementation of various forms of circuits as necessary, circuit integration, and product simplification.

### Brief Description of Drawings

FIGS. 1 through 12 are mimetic diagrams illustrating a method of manufacturing a printed circuit board (PCB) including a metal core layer with a via hole according to embodiments of the present invention.
FIGS. 13 through 15 are mimetic diagrams illustrating a method of manufacturing a multilayer PCB using the PCB manufactured using the method described with reference to FIGS. 1 through 12.
FIGS. 16 and 17 are mimetic diagrams illustrating a method of processing conduction in an inner layer of the multilayer PCB manufactured using the method described with reference to FIGS. 13 through 15.
FIGS. 18 through 24 are mimetic diagrams illustrating a method of manufacturing a PCB including a metal core layer without a via hole according to embodiments of the present invention.
FIGS. 25 through 27 are mimetic diagrams illustrating a method of manufacturing a multilayer PCB using the PCB manufactured using the method described with reference to FIGS. 18 through 24.

### Best Mode for Carrying Out Invention

Reference will now be made in detail to embodiments of the present invention, examples of which are illustrated in the accompanying drawings, wherein like reference numerals refer to the like elements throughout. The embodiments are described below in order to explain the present invention by referring to the figures. In descriptions of illustrative examples provided herein, known functions or configurations may be omitted to clearly deliver a point of the present invention.

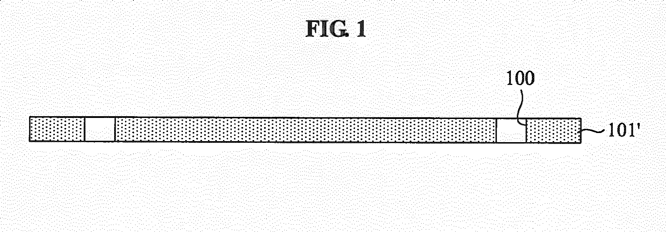

Hereinafter, a method of manufacturing a printed circuit board (PCB) including a metal core layer with a via hole will be described in detail with reference to FIGS. 1 through 12. Unless indicated otherwise, a phrase "on a layer" may refer to "on both an upper face and a lower face of the layer."

Referring to FIG. 1, a metal core layer 101' is prepared. The metal core layer 101' is formed of an aluminum material having a predetermined thickness. The metal core layer 101' includes a core pattern 100 formed therein and formed as at least one hole. For example, the core pattern 100 may be formed as a predetermined pattern or formed as a plurality of holes arranged regularly or irregularly. With the formation of the predetermined pattern, the core pattern 100 may form a predetermined circuit pattern on the metal core layer 101'. In addition, the core pattern 100 may enable a desirable heat radiation from the metal core layer 101'. The core pattern 100 may be formed on the metal core layer 101' through a chemical or mechanical method. For example, the core pattern 100 may be formed on the metal core layer 101 through chemical etching. Alternatively, the core pattern 100 may be formed as the hole by punching the metal core layer 101'.

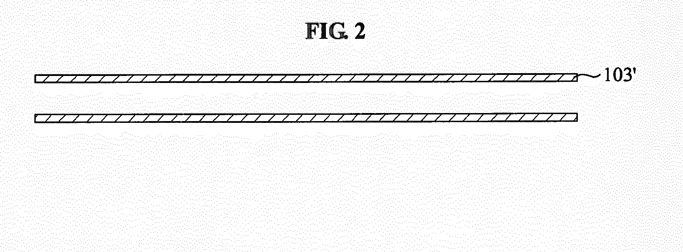

Referring to FIG. 2, a base layer 103' is prepared. For example, an aluminum foil having a predetermined thickness may be used for the base layer 103'.

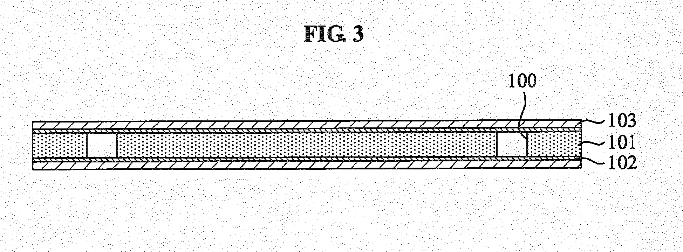

Referring to FIG 3, a base layer 103 is bonded on both sides of a metal core layer 101. Here, the base layer 103 is bonded onto the metal core layer 101 using a bonding member 102.

For example, a polyimide-based insulating bonding sheet, which is a binder having a desirable bonding performance and insulating function, or an epoxy type such as glass epoxy resin may be used for the bonding member 102. A material having a thermal expansion coefficient similar to a thermal expansion coefficient of the base layer 103 may be used for the bonding member 102. Since polyimide endures at a high temperature of 400 °C or above or at a low temperature of -269 °C, polyimide may absorb a change rate based on a thermal expansion coefficient of aluminum, for example, 23.03 x 10-6 °C. Thus, to bond the base layer 103 onto the metal core layer 101, a predetermined temperature and pressure may be applied to the base layer 103.

Here, surface treatment may be performed to form surface roughness on each of the metal core layer 101' and the base layer 103' prepared with reference to FIGS. 1 and 2 in order to improve a bonding performance between the bonding member 102 and the metal core layer 101, and between the bonding member 102 and the base layer 103. For example, soft etching may be performed on a surface of the metal core layer 101' on which surface roughness is not formed using a sulfuric acid type. Alternatively, oxidation treatment may be performed to form the surface roughness. Similarly, soft etching may be performed to form surface roughness on a surface of the base layer 103' on which surface roughness is not formed using a sulfuric acid type. Alternatively, an oxidation treatment may be performed to form the surface roughness.

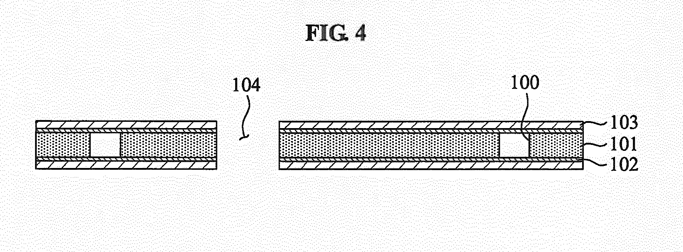

Referring to FIG. 4, a via hole 104 is formed to penetrate the metal core layer 101 and the base layer 103 in a state in which the base layer 103 is bonded onto the metal core layer 101. For example, the via hole 104 may be formed by drilling or laser processing.

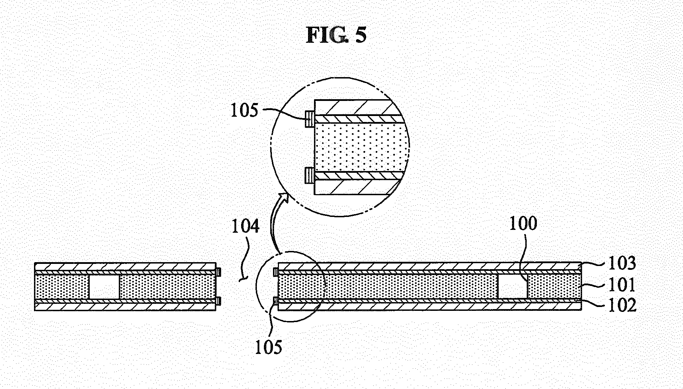

Referring to FIG 5, a metal layer 105 is formed to metalize a portion of the bonding member 102 exposed to an inner side face of the via hole 104. For example, a carbon plating layer may be formed on the metal layer 105 through carbon direct plating. With the formation of the metal layer 105, the base layer 103 formed on and below the metal core layer 101 may be electrically connected. As illustrated in FIG. 5, the metal layer 105 is formed to be connected to a portion of the metal core layer 101 and the base layer 103 to allow the metal layer 105 to electrically connect the metal core layer 101 and the base layer 103.

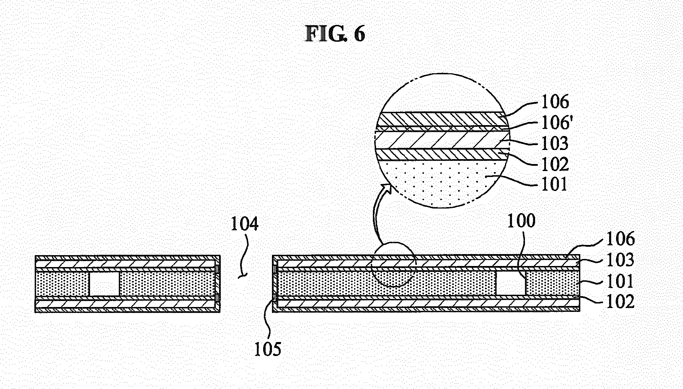

Referring to FIG. 6, a substitution layer 106 having a predetermined thickness is formed by performing zincate treatment on a surface of the base layer 103 in a state in which the metal layer 105 is formed. The substitution layer 106 is formed through a portion of the surface of the base layer 103 being substituted by a zinc film. The substitution layer 106 is formed on an area from which the metal layer 105 is excluded, for example, the surface of the base layer 103 and a cross-sectional portion of the base layer 103 and the metal core layer 101, which is exposed to an inner side of the via hole 104. Here, the substitution layer 106 is formed to have a thickness equal to a thickness of the metal layer 105 based on the thickness of the metal layer 105. As illustrated as 106' in FIG. 6, the substitution layer 106 is formed by a portion of a surficial thickness of the base layer 103 being substituted. However, the present invention may not be limited such examples illustrated in the drawings, and the thickness of the substitution layer 106 and the thickness of the base layer 103 to be substituted as illustrated as 106' may vary.

With the formation of the substation layer 106, aluminum may be prevented from being oxidized in an atmosphere and thus, the surface of the base layer 103 may be protected. In addition, by substituting the zinc film for the surface of the base layer 103, corrosion of the surface of the base layer 103 that may occur during electroless plating to be subsequently performed may be prevented.

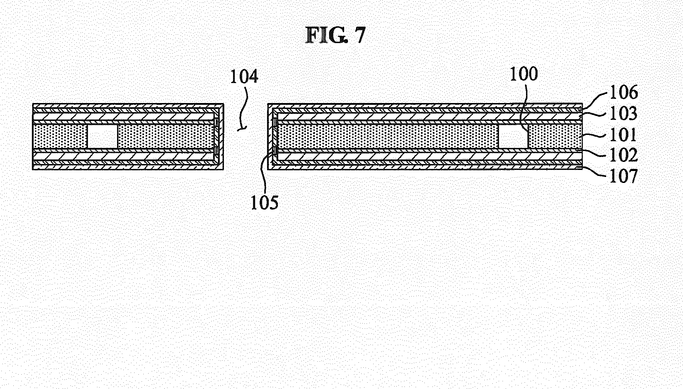

Referring to FIG. 7, a substitution plating layer 107 is formed on the substitution layer 106. The substitution plating layer 107 is formed also on a surface of the metal layer 105 in the via hole 104 in addition to the substitution layer 106. The substitution plating layer 107 is formed using electrolytic or electroless plating.

The substitution plating layer 107 is formed by performing displacement plating on the substitution layer 106 using a metal film having a strong chemical resistance. For example, the substitution plating layer 107 is formed by performing the displacement plating using nickel (Ni) to substitute a nickel film for the substitution layer 106. However, the displacement plating may not be limited to using nickel. Other metals having a strong chemical resistance, for example, gold (Au) and silver (Ag), may be used to perform the displacement plating.

Although a partial thickness of the substitution layer 106 is substituted by the nickel film through the nickel displacement plating, the present invention may not be limited thereto. A case in which both the metal layer 105 and the substitution layer 106 are substituted for with the substitution plating layer 107 may be considered.

The substitution plating layer 107 is formed only on the substitution layer 106 apart from the metal layer 105. Alternatively, the substitution plating layer 107 is formed to cover a portion or an entirety of the metal layer 105.

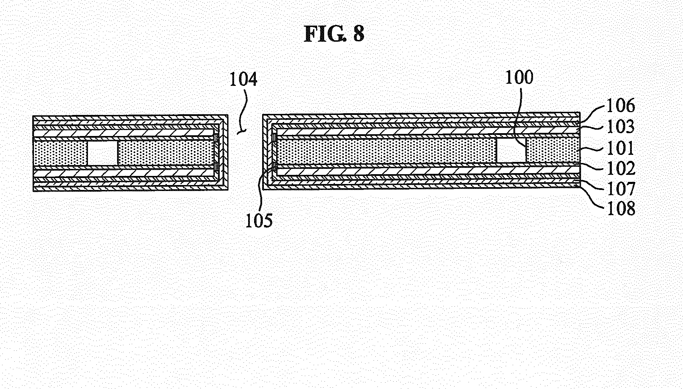

Referring to FIG. 8, an electrolytic plating layer 108 is formed on the substitution plating layer 107. The electrolytic plating layer 108 is formed also on the substitution plating layer 107 in the via hole 104. For example, the electrolytic plating layer 108 may be a copper film formed by copper plating. The electrolytic plating layer 108 is formed using electrolytic plating. For example, the electrolytic plating layer 108 is formed to have a thickness of 20 micrometers (µm) or thicker.

Here, the metal layer 105 is formed to be covered by at least one of the substitution plating layer 107 and the electrolytic plating layer 108. In detail, when the substitution plating layer 107 is formed only on the substitution layer 106 apart from the metal layer 105, the electrolytic plating layer 108 is formed to cover both the substitution plating layer 107 and the metal layer 105 and thus, only the electrolytic plating layer 108 is formed on the metal layer 105. When the substitution plating layer 107 is formed to cover a portion of the metal layer 105, the electrolytic plating layer 108 is formed to cover both the substitution plating layer 107 and the metal layer 105. When the substitution plating layer 107 is formed to fully cover the metal layer 105, the electrolytic plating layer 108 is formed to cover the substitution plating layer 107 and thus, a double layer of the substitution plating layer 107 and the electrolytic plating layer 108 is formed on the metal layer 105.

By forming the substitution layer 106 first, binding power between the substitution layer 106 and the base layer 103, and the substitution layer 106 and the plating layers, for example, the substitution plating layer 107 and the electrolytic plating layer 108, may be improved. Thus, the base layer 103, the substitution layer 106, and the plating layers, for example, separation of the substitution plating layer 107 and the electrolytic plating layer 108 from one another due to vibration may be effectively prevented, and accordingly, may be suitably used in an environment such as in a vehicle in which a great amount of vibration occurs.

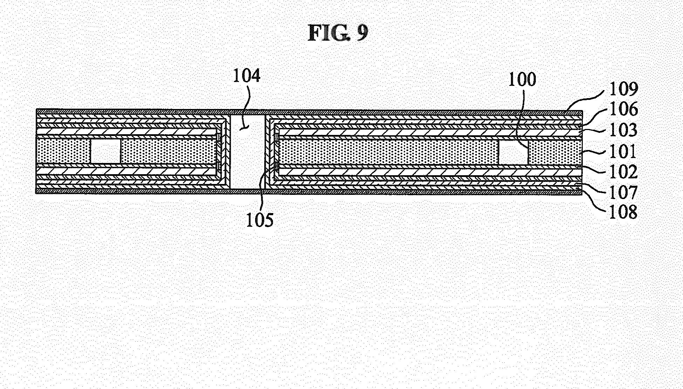

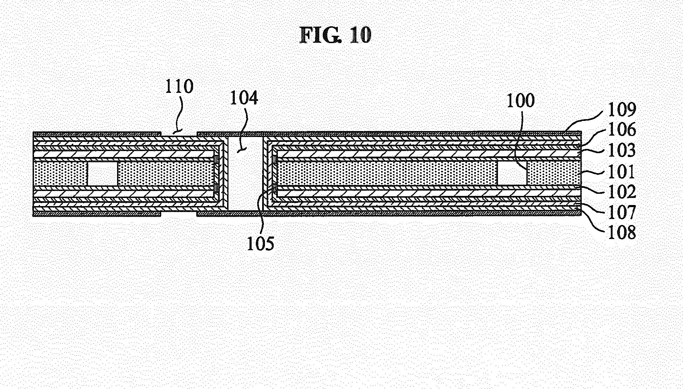

Referring to FIGS. 9 and 10, a dry film 109 is applied onto a surface of the electrolytic plating layer 108 to form a predetermined pattern 110. For example, the pattern 110 of the dry film 109 is formed by printing a pattern on the dry film 109 and performing exposure and development for a predetermined amount of time.

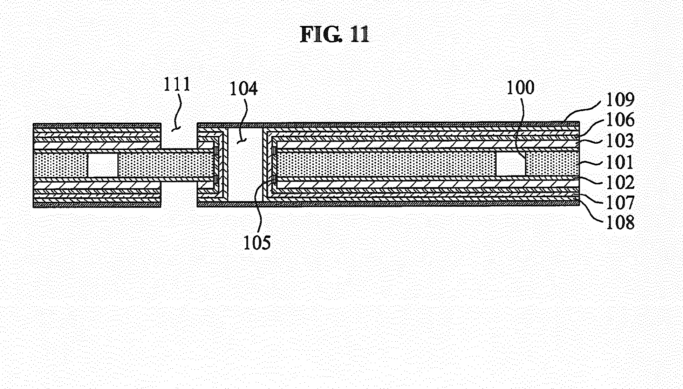

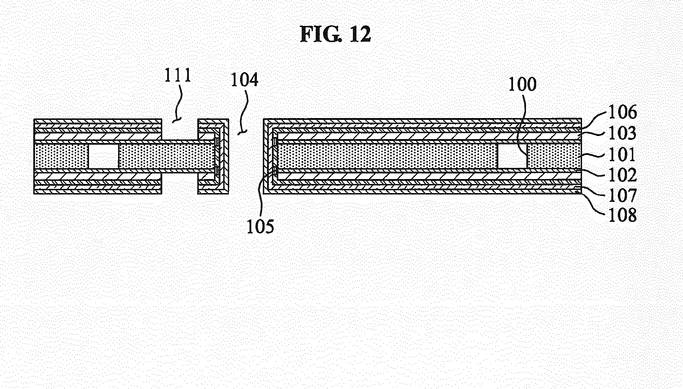

Referring to FIGS. 11 and 12, the electrolytic plating layer 108, the substitution plating layer 107, the substitution layer 106, and the base layer 103 are removed along the pattern 110 of the dry film 109 to form a predetermined circuit pattern 111. Subsequent to the formation of the circuit pattern 111, the dry film 109 is removed to form a PCB in which the circuit pattern 111 is formed. The circuit pattern 111 is formed using hydrochloric acid-based acidic etching based on the pattern 110 on the dry film 109. Here, a hydrochloric acid type such as ferric chloride, cupric chloride, and sodium chlorate may be used.

As described in the foregoing, the circuit pattern 110 may be formed using a mechanical method such as punching in addition to using a chemical method using the dry film 109 and the hydrochloric acid-based acidic etching.

The PCB manufactured in accordance with the method described with reference to FIGS. 1 through 12 may be applied to electronic components for a vehicle.

Hereinafter, a method of manufacturing a multilayer PCB using the PCB manufactured using the method described with reference to FIGS. 1 through 12 will be described.

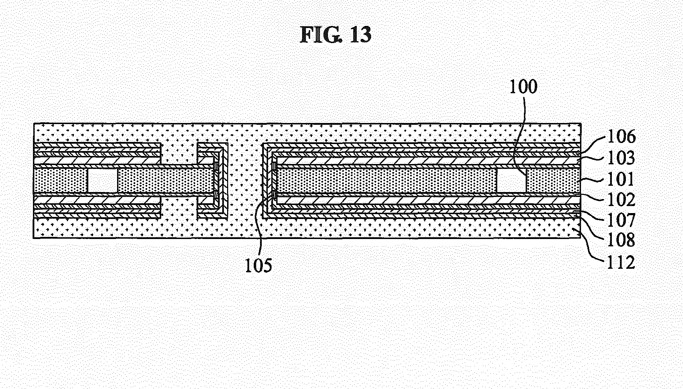

Referring to FIG. 13, an insulation layer 112 of an insulating material is formed on the PCB manufactured using the method described with reference to FIGS. 1 through 12. The insulation layer 112 is formed to fill both the via hole 104 and the circuit pattern 111 of the PCB.

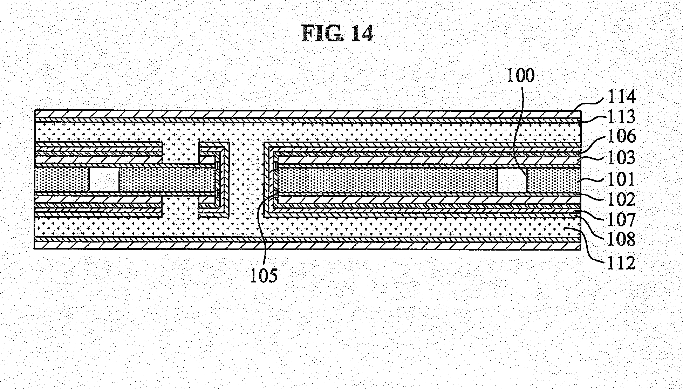

Referring to FIG. 14, a base layer 114 is formed on the insulation layer 112. The base layer 114 is formed on an upper face and a lower face of the insulation layer 112. An aluminum foil having a predetermined thickness may be used for the base layer 114. To improve a bonding performance of a surface of the base layer 114, surface roughness is formed on the base layer 114 using sulfuric acid-based soft etching or oxidation treatment.

To bond the base layer 114 onto the insulation layer 112, a bonding member 113 such as a polyimide-based insulating bonding sheet or an epoxy type may be used.

Here, surface treatment is performed to improve the surface roughness in order to improve binding power between the base layer 114 and the bonding member 113.

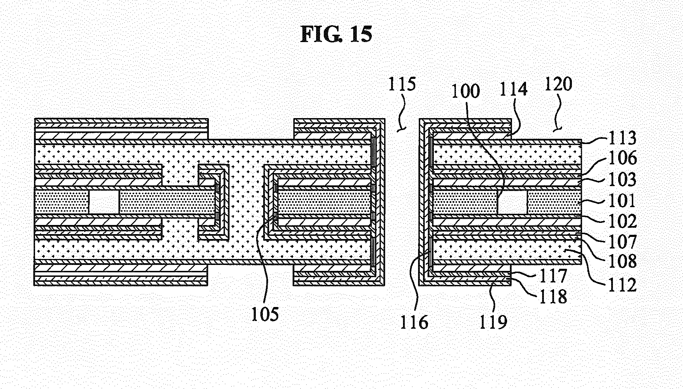

Referring to FIG. 15, in a state in which the insulation layer 112, the bonding member 113, and the base layer 114 are formed in the PCB, a second via hole 115 is formed, and a metal layer 116, a substitution layer 117, a substitution plating layer 118, and an electrolytic plating layer 119 are sequentially formed. Subsequently, a predetermined circuit pattern 120 is formed using a dry film to form the multilayer PCB. For a method of forming the second via hole 115 and the circuit pattern 120, reference may be made to the descriptions provided with reference to FIGS. 4 through 12 and thus, repeated descriptions are omitted here for brevity.

The circuit pattern 120 is formed using a chemical method using the dry film and hydrochloride acid-based acidic etching. The chemical method may be used to selectively remove a layer because selective removal of the electrolytic plating layer 119, the substitution plating layer 118, the substitution layer 117, and up to the base layer 114 for the circuit pattern 120 is necessary.

Alternatively, a mechanical method using punching and the like may be used in addition to the chemical method using the dry film and the hydrochloride acid-based acidic etching in order to form a circuit pattern on a based layer to be formed in a multilayer PCB. In addition, only a through hole may be formed to connect an electrode or a metal layer in a predetermined form.

Although forming a double-layered PCB is illustrated, the present invention may not be limited thereto. Thus, a high multilayer PCB having three or more layers may be formed by repetitively performing operations described with reference to FIGS. 13 through 15.

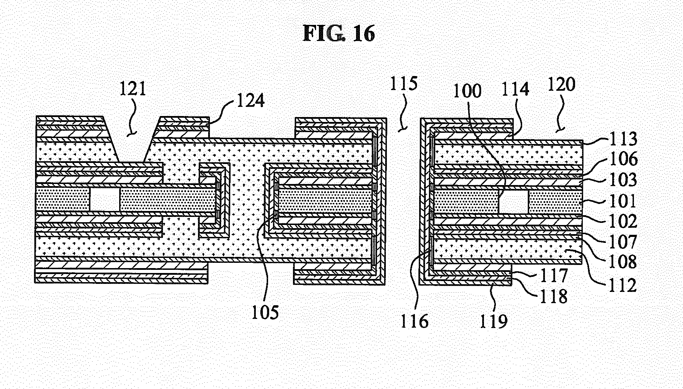

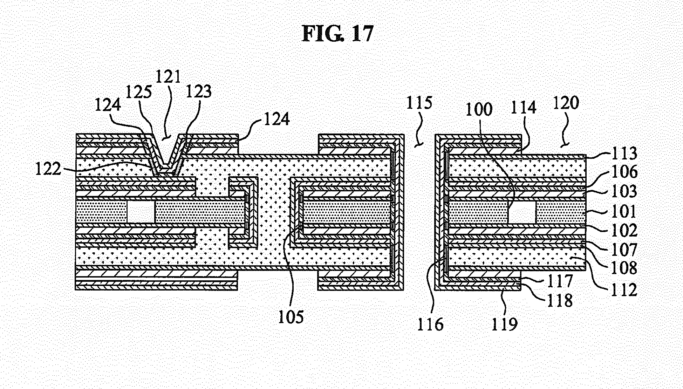

Here, inner layers in the multilayer PCB formed using the method described with reference to FIGS. 13 through 15 may need to be electrically conducted. A detailed method for such an electrical conduction among the inner layers will be described with reference to FIGS. 16 and 17.

Referring to FIG. 16, a third via hole 121 is formed for the conduction in the manufactured multilayer PCB. The third via hole 121 electrically connects a circuit pattern of a PCB formed inside to a circuit pattern of a PCB layered on the PCB formed internally. For such an electrical conduction, the third via hole 121 is formed to allow the electrolytic plating layer 108 to be exposed from the PCB formed inside by removing all the electrolytic plating layer 119, the substitution plating layer 118, the substitution layer 117, the base layer 114, the bonding member 113, and the insulation layer 112. For example, the third via hole 121 may be formed by drilling or laser processing.

Referring to FIG 17, a metal layer 122 is formed to metalize a surface of the insulation layer 112 and the bonding member 113, which is exposed to an inner side of the third via hole 121. A substitution layer 123, a substitution plating layer 124, and an electrolytic plating layer 125 are sequentially formed. Here, for a method of forming the metal layer 122, the substitution layer 123, the substitution plating layer 124, and the electrolytic plating layer 125, reference may be made to the descriptions provided with reference to FIGS. 5 through 8 and thus, repeated descriptions are omitted here for brevity.

The metal layer 122 electrically connects the electrolytic plating layer 108 in the third via hole 121 to the electrolytic plating layer 119 out of the third via hole 121, and functions as a conducting wire that electrically connects an internal PCB and a layered PCB.

A thickness of the substitution layer 123, the substitution plating layer 124, and the electrolytic plating layer 125 formed in the third via hole 121 is equal to a thickness of the substitution layer 117, the substitution plating layer 118, and the electrolytic plating layer 119 formed in the layered PCB.

The substitution plating layer 123 and the electrolytic plating layer 124 are formed to cover the metal layer 122 in the third via hole 121. In detail, when the substitution plating layer 123 does not cover the metal layer 122, the electrolytic plating layer 124 is formed to fully cover the metal layer 122. When the substitution plating layer 123 is formed to cover a portion of the metal layer 122, the electrolytic plating layer 124 is formed to cover the metal layer 122 and the substitution plating layer 123. When the substitution plating layer 123 is formed to fully cover the metal layer 122, the electrolytic plating layer 124 is formed on an upper face of the substitution plating layer 123. That is, the metal layer 122 is covered by at least one of the substitution plating layer 123 and the electrolytic plating layer 124.

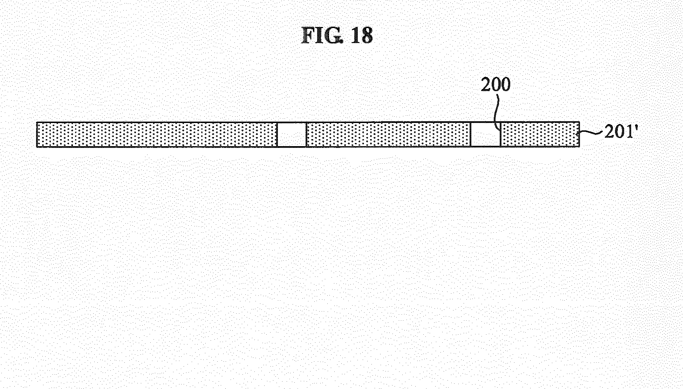

Although a method of manufacturing a PCB and a multilayer PCB with a via hole being formed is illustrated in the foregoing, the method may be identically applicable to a case in which the via hole is not formed. Hereinafter, a method of manufacturing a PCB including a metal core layer without a via hole will be described in detail with reference to FIGS. 18 through 24. The example embodiments described with reference to FIGS. 1 through 12 may be substantially identical to example embodiments to be described hereinafter, except for an absence of the via hole.

Referring to FIG. 18, a metal core layer 201' formed of an aluminum material and having a predetermined thickness is prepared. A core pattern 200 formed as at least one hole is formed on the metal core layer 201'. For example, the core pattern 200 is formed as a predetermined pattern or formed with a plurality of holes arranged regularly or irregularly. With the formation of the predetermined pattern, the core pattern 200 may form a predetermined circuit pattern on the metal core layer 201'. In addition, the core pattern 200 may allow heat to be desirably radiated from the metal core layer 201'. Here, the core pattern 200 may be formed on the metal core layer 201' using a chemical or mechanical method. For example, the core pattern 200 may form the pattern on the metal core layer 201' using chemical etching. Alternatively, the core pattern 200 may form the hole on the metal core layer 201' through punching.

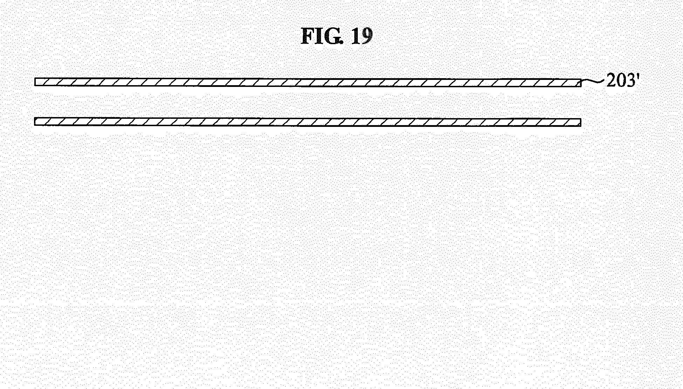

Referring to FIG. 19, a base layer 203' formed of an aluminum foil having a predetermined thickness is formed.

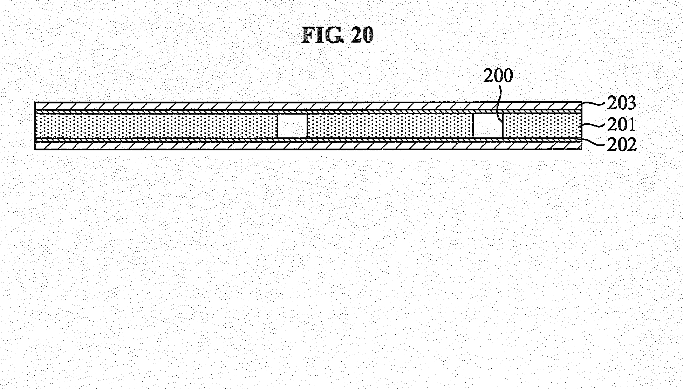

Referring to FIG. 20, a base layer 203 is bonded on both sides of a metal core layer 201. The base layer 203 is bonded onto the metal core layer 201 using a bonding member 202. For example, a polyimide-based insulating bonding sheet or an epoxy type may be used for the bonding member 202.

Here, a surface treatment is performed to form surface roughness on each of the metal core layer 201' and the base layer 203' in order to improve a bonding performance between the bonding member 202 and the metal core layer 201, and the bonding member 202 and the base layer 203. For example, soft etching may be performed on a surface of the metal core layer 201' on which surface roughness is not formed using a sulfuric acid type, or oxidation treatment may be performed to form the surface roughness. Similarly, soft etching may be performed on a surface of the base layer 203' on which surface roughness is not formed using a sulfuric acid type, or oxidation treatment may be performed to form the surface roughness.

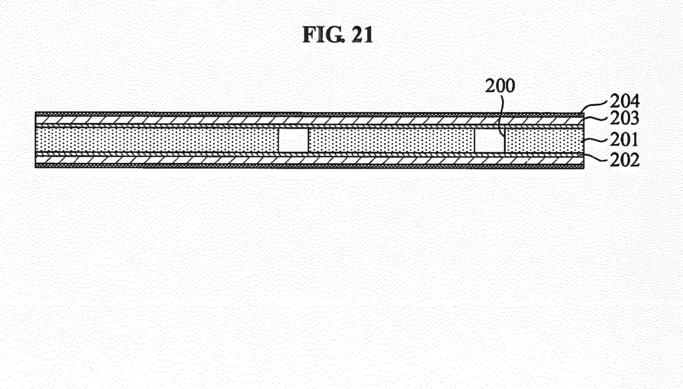

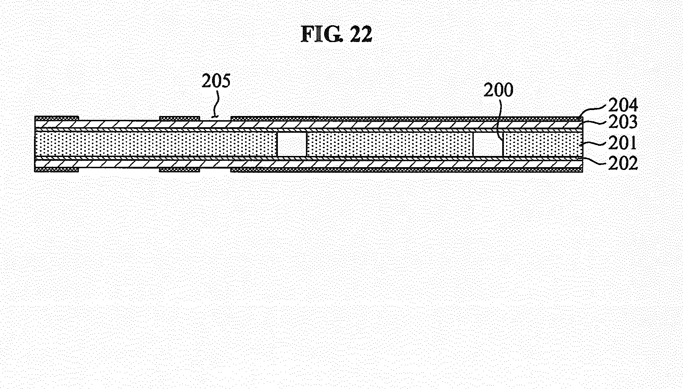

Referring to FIG 21, a dry film 204 is applied onto the base layer 203. Referring to FIG 22, a predetermined pattern 205 is formed through exposure and development.

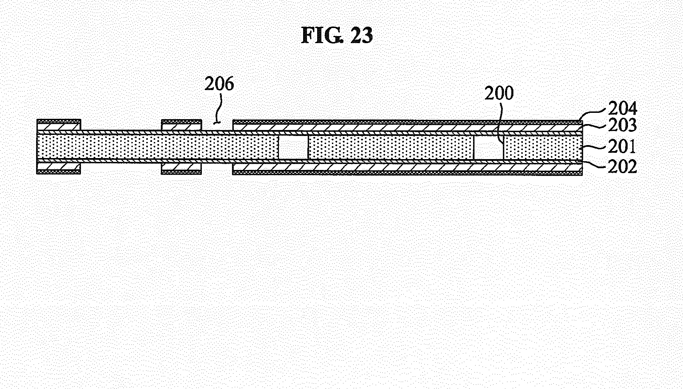

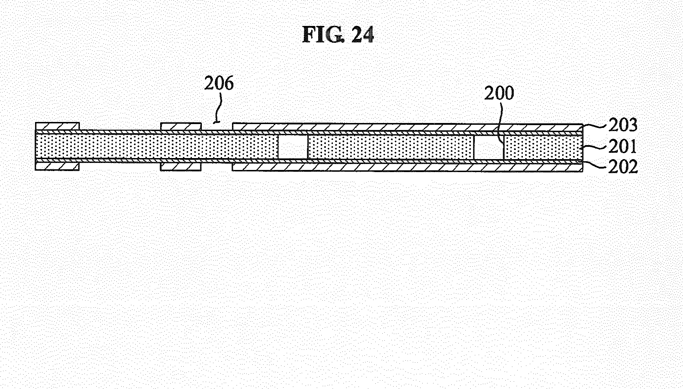

Referring to FIG 23, a circuit pattern 206 is formed by removing the base layer 203 based on the pattern 205 of the dry film 204. Referring to FIG. 24, a PCB is formed by removing the dry film 204.

Although an example of forming a circuit pattern directly on the base layer 203 is described, the present invention may not be limited to the provided example. Thus, forming a plating layer on the base layer 203 using electrolytic or electroless plating may be possible.

The circuit pattern 206 may be formed through a chemical method the hydrochloride acid-based acidic etching using the dry film 204. Alternatively, the circuit pattern 206 may be formed through a mechanical method such as punching. Alternatively, the circuit pattern 206 may be formed only as a through hole to connect an electrode or a metal layer in a predetermined form.

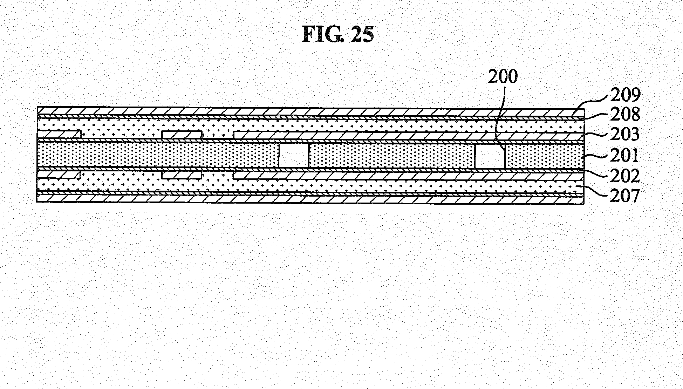

FIGS. 25 through 27 are mimetic diagrams illustrating a method of manufacturing a multilayer PCB using the PCB manufactured using the method described with reference to FIGS. 17 through 24.

Referring to FIG. 25, an insulation layer 207 having a predetermined thickness is formed to fill the circuit pattern 206 of the PCB manufactured using the method described with reference to FIGS. 17 through 24. A base layer 209 is bonded onto the insulation layer 207 using a bonding member 208. For example, the base layer 209 is an aluminum foil having a predetermined thickness, and a polyimide-based insulating bonding sheet or an epoxy type may be used for the bonding member 208.

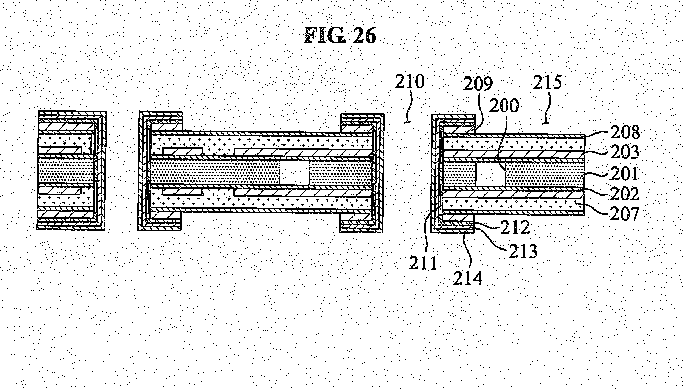

Referring to FIG. 26, a via hole 210 is formed to penetrate the PCB in which the insulation layer 207, the bonding member 208, and the base layer 209 are formed. For example, the via hole 210 may be formed by drilling or laser processing. A metal layer 211 is formed to metalize a cross-sectional portion of the insulation layer 207 and the bonding member 208, which is exposed to an inner side of the via hole 210. A substitution layer 212, a substitution plating layer 213, and an electrolytic plating layer 214 are sequentially formed. Here, the metal layer 211 is formed to be connected to a portion of the metal core layer 201 and the base layer 203 disposed on both sides of the insulation layer 207 and the bonding member 208 in addition to a portion of the insulation layer 207 and the bonding member 208 to electrically connect the metal core layer 201 and the base layer 203. In addition, the metal layer 211 is formed to be covered by at least one of the substitution plating layer 213 and the electrolytic plating layer 214.

For a method of forming the metal layer 211, the substitution layer 212, the substitution plating layer 213, and the electrolytic plating layer 214, reference may be made to the descriptions provided with reference to FIGS. 5 through 8 and thus, repeated descriptions are omitted here for brevity.

A dry film is applied onto the electrolytic plating layer 214, and a predetermined pattern is formed through exposure and development for a predetermined amount of time. A predetermined circuit pattern is formed using the dry film on which the pattern is formed. The circuit pattern is formed by removing the electrolytic plating layer 214, the substitution plating layer 213, the substitution layer 212, and up to the base layer 209 using hydrochloride acid-based acidic etching using the dry film.

Here, the circuit pattern is formed through a chemical method the hydrochloride acid-based acidic etching using the dry film. The chemical method may be used to selectively remove a layer because up to the base layer 209 is needed to be removed in addition to the electrolytic plating layer 214, the substitution plating layer 213, and the substitution layer 212.

In addition to the chemical method using the dry film and the hydrochloride acid-based acidic etching, a mechanical method such as punching may be used to form a predetermined pattern on a base layer to be layered in a multilayer PCB. Alternatively, only a through hole may be formed to connect an electrode or a metal layer in a predetermined form.

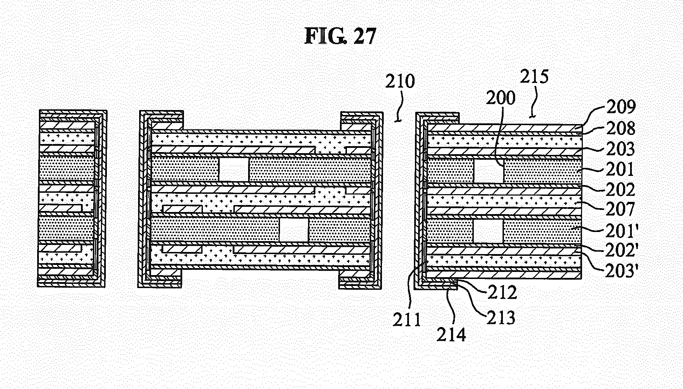

Although an example of forming a double-layered PCB is described, a high multilayer PCB, for example, a PCB with three or more layers, may be formed by repetitively performing operations described with reference to FIGS. 25 and 26. Referring to FIG 27, a high multilayer PCB is formed by layering two PCBs manufactured using the method described with reference to FIGS. 17 through 24. Alternatively, a high multilayer PCB may be formed by layering at least three PCBs using a method to be described with reference to FIG. 27. As described with reference to FIGS. 25 and 26, the multilayer PCB of FIG. 27 is formed by forming the insulation layer 207 between the PCBs to be bonded to each other, forming the base layer 209 on the insulation layer 207 using the bonding member 208, and sequentially forming the metal layer 211, the substitution layer 212, the substitution plating layer 213, and the electrolytic plating layer 214, and forming the circuit pattern 217 using the dry film.

While this disclosure includes specific examples, it will be apparent to one of ordinary skill in the art that various changes in form and details may be made in these examples without departing from the spirit and scope of the claims and their equivalents. The examples described herein are to be considered in a descriptive sense only, and not for purposes of limitation. Descriptions of features or aspects in each example are to be considered as being applicable to similar features or aspects in other examples. Suitable results may be achieved if the described techniques are performed in a different order, and/or if components in a described system, architecture, device, or circuit are combined in a different manner and/or replaced or supplemented by other components or their equivalents.

Therefore, the scope of the disclosure is defined not by the detailed description, but by the claims and their equivalents, and all variations within the scope of the claims and their equivalents are to be construed as being included in the disclosure.

## Claims

1. A printed circuit board (PCB), comprising:
a core portion formed of an aluminum material;
a base layer formed of an aluminum material and bonded on both sides of the core portion;
a bonding member interposed between the core portion and the base layer to bond the base layer to the core portion;
a via hole formed to penetrate the core portion, the bonding member, and the base layer;
a substitution layer formed to zincify a surface of the base layer and a portion exposed to an inner side of the via hole; and
a plating layer formed on the substitution layer and comprising a circuit pattern formed thereon.

2. The PCB of claim 1, further comprising:
a metal layer formed to metalize a portion of the bonding member exposed to the inner side of the via hole, and
wherein the substitution layer is formed on a portion from which the metal layer is excluded, and
the plating layer is formed to cover the metal layer.

3. The PCB of claim 2, wherein the plating layer comprises a substitution plating layer formed on a surface of the substitution layer through electrolytic or electroless plating, and an electrolytic plating layer formed on the substitution plating layer through the electrolytic plating.

4. The PCB of claim 3, wherein the substitution plating layer is formed on the surface of the substitution layer from which the metal layer is excluded or formed to cover a portion of the metal layer, and
the electrolytic plating layer is formed to cover a portion of the metal layer on which the substitution plating layer is not formed.

5. The PCB of claim 1, wherein the core portion is formed of the aluminum material having a predetermined thickness, and is a metal core layer comprising a core pattern formed thereon.

6. The PCB of claim 1, wherein the core portion comprises:
a metal core layer formed of an aluminum material having a predetermined thickness and comprising a core pattern formed thereon;
a core base layer formed of an aluminum material and bonded on both sides of the metal core layer; and
a core bonding member interposed between the metal core layer and the core base layer to bond the core base layer to the metal core layer.

7. The PCB of claim 6, further comprising:
a circuit pattern formed on the core base layer, and
wherein an insulation layer is formed on the core base layer.

8. The PCB of claim 7, wherein the metal layer is formed to metalize a portion of the bonding member, the core bonding member, and the insulation layer, which is exposed to the inner side of the via hole, and
the plating layer is formed to cover the metal layer.

9. The PCB of claim 6, further comprising:
an insulation layer formed between the core portion and the bonding member; and
a metal layer formed to metalize a portion of the core bonding member, the bonding member, and the insulation layer, which is exposed to the inner side of the via hole, and
wherein the substitution layer is formed on a portion from which the metal layer is excluded, and
the plating layer is formed to cover the metal layer.

10. The PCB of claim 5 or 6, wherein the core pattern is formed as at least one hole penetrating the metal core layer, and
wherein the hole is formed as a pattern or arranged regularly or irregularly.

11. The PCB of claim 10, wherein the metal core layer is formed by performing surface treatment to form surface roughness.

12. The PCB of claim 1, comprising:
an insulation layer formed on the circuit pattern;
a second base layer formed of an aluminum material and bonded to the insulation layer using a second bonding member;
a second substitution layer formed to zincify a surface of the second base layer; and
a second plating layer formed on the second substitution layer, and
wherein the insulation layer, the second base layer, the second substitution layer, and the second plating layer are repetitively layered at least once, and
a second via hole is formed to fully penetrate the insulation layer, the second base layer, the second substitution layer, and the second plating layer.

13. The PCB of claim 12, further comprising:
a second metal layer formed to metalize a portion of the bonding member, the insulation layer, and the second bonding member, which is exposed to an inner side of the second via hole, and
wherein the second substitution layer is formed on a portion from which the second metal layer is excluded, and
the second plating layer is formed to cover the second metal layer.

14. The PCB of claim 1, wherein the core portion comprises:
a metal core layer formed of an aluminum material having a predetermined thickness and comprising a core pattern formed thereon;
a core bonding member formed on both sides of the metal core layer;
a core base layer formed of an aluminum material and bonded to the metal core layer using the core bonding member;
a second core bonding member formed on each of the core base layer; and
a second core base layer formed of an aluminum material and bonded to each of the core base layer using the second core bonding member.

15. A method of manufacturing a printed circuit board (PCB), comprising:
providing a core portion of an aluminum material;
bonding a base layer having a predetermined thickness to the core portion using a bonding member;
forming a via hole penetrating the core portion, the bonding member, and the base layer;
forming a substitution layer by zincifying a surface of the base layer and a portion exposed to an inner side of the via hole;
forming a plating layer on the substitution layer; and
forming a predetermined circuit pattern on the plating layer.

16. The method of claim 15, further comprising:
forming a metal layer to metalize a portion of the bonding member exposed to the inner side of the via hole, and
wherein the forming of the substitution layer comprises forming the substitution layer on a portion from which the metal layer is excluded, and
the forming of the plating layer comprises forming the plating layer to cover the metal layer.

17. The method of claim 16, wherein the forming of the plating layer comprises:
forming a substitution plating layer on a surface of the substitution layer using electrolytic or electroless plating; and
forming an electrolytic plating layer formed of a cupric material and formed on the substitution plating layer using the electrolytic plating.

18. The method of claim 17, wherein the substitution plating layer is formed on the surface of the substitution layer from which the metal layer is excluded, or formed to cover a portion of the metal layer, and
the electrolytic plating layer is formed to cover a portion of the metal layer on which the substitution plating layer is not formed.

19. The method of claim 15, wherein the core portion is formed of the aluminum material having a predetermined thickness and formed as a metal core layer on which a core pattern is formed, and further comprising:
performing surface treatment to form surface roughness of the metal core layer.

20. The method of claim 15, wherein the providing of the core portion comprises:
providing a metal core layer formed of an aluminum material having a predetermined thickness;
forming a core pattern on the metal core layer; and
bonding a core base layer of an aluminum material on both sides of the metal core layer on which the core pattern is formed using a core bonding member.

21. The method of claim 20, further comprising:
forming a second circuit pattern on the core base layer; and
providing an insulation layer on the core base layer.

22. The method of claim 20, further comprising:
bonding a second core base layer of an aluminum material to each of the core base layer using a second core bonding member.

23. The method of claim 20, further comprising:
forming an insulation layer to fill the circuit pattern;
bonding a second base layer of an aluminum material to the insulation layer using a second bonding member;
forming a second via hole penetrating the metal core layer, the bonding member, the base layer, the insulation layer, the second bonding member, and the second base layer;
forming a metal layer to metalize a surface of the bonding member and the second bonding member, which is exposed to an inner side of the second via hole;
forming a substitution layer by performing surface treatment to zincify a surface of the second base layer, and a portion of the second base layer, the base layer, and the insulation layer, which is exposed to the inner side of the second via hole, apart from the metal layer;
forming a plating layer on the substitution layer using electrolytic or electroless plating; and
forming a circuit pattern on the plating layer.

24. The method of claim 19 or 20, wherein the core pattern is formed as at least one hole penetrating the metal core layer, and
wherein the hole is formed as a pattern or arranged regularly or irregularly.

25. The method of claim 24, further comprising:
performing surface treatment to form surface roughness of the metal core layer.

26. The method of claim 15, further comprising:
forming a secondary substrate by forming the circuit pattern;
layering two secondary substrates on which the circuit pattern is formed;
forming an insulation layer between the layered secondary substrates and on an uppermost face and a lowermost face of the secondary substrate;
bonding a second base layer of an aluminum material to the insulation layer using a second bonding member;
forming a via hole penetrating the layered secondary substrates, the insulation layer, the second bonding member, and the second base layer;
forming a metal layer to metalize a portion of the bonding member and the second bonding member of the secondary substrate, which is exposed to an inner side of the via hole;
forming a substation layer by performing surface treatment to zincify a surface of the second base layer, and a portion of the second base layer, the base layer, and the insulation layer, which is exposed to the inner side of the via hole, apart from the metal layer;
forming a plating layer on the substitution layer using electrolytic or electroless plating; and
forming a circuit pattern on the plating layer.
